# EUROPEAN PATENT APPLICATION

(11) **EP 4 796 669 A1**
(43) Date of publication of application: **26.08.2026**
(21) Application number: 26159735.5
(22) Date of filing: 20.02.2026
(51) Int. Cl.: C23C 16/44, B08B 7/00, C30B 25/00, C30B 29/36, H01J 37/32, C23C 16/32, H10P 14/20, H10P 70/00, H10P 72/00

(54) **METHOD AND ASSEMBLY FOR THE REMOVAL OF SILICON CARBIDE FROM REACTOR PARTS**

(30) Priority: 24.02.2025 IT 202500003567
(71) Applicant: LPE S.p.A., 20021 Baranzate (MI) (IT)
(72) Inventor: VALENTE, Gianluca, Milano (MI) (IT)
(74) Representative: Buzzi, Notaro & Antonielli d'Oulx S.p.A.

(57) **Abstract**

A method for removing an accretion from one or more workpieces, comprising the steps of: i) supporting one or more workpieces having the accretion in a supporting arrangement, the accretion comprising silicon carbide in polycrystalline and/or amorphous form; ii) removing a first portion of the accretion by executing at least one cycle of an etching process; iii) removing a second portion of the accretion by executing at least one cycle of a physical cleaning process; wherein said physical cleaning process is executed with a mechanical device and/or a pneumatic device. An assembly configured to carry out the method is also disclosed.

## Description

### FIELD OF INVENTION

The present invention relates to the field of epitaxial deposition of semiconductor films on substrates; in particular to a method and to an assembly adapted to execute the removal of silicon carbide from reactor parts.

Additionally, though not exclusively, the present invention relates to the field of the deposition of silicon carbide films on a semiconductor substrate in a hot-wall, crossflow homoepitaxial or heteroepitaxial reactor.

### BACKGROUND OF THE DISCLOSURE

Semiconductor layers made by epitaxial growth, also known as epilayers, are formed by deposition in the reaction chamber of a reactor.

Typically, the reaction chamber is heated to a desired temperature before deposition, and then the temperature is maintained substantially constant throughout the deposition process.

In case of epitaxial reactors for the deposition of silicon carbide, the chamber may be effectively heated to 1300-1700 °C via induction means.

The reaction chamber may comprise one or more structural parts, such as one or more walls. These can be made of a susceptive material, for example graphite, which is effectively heated by induction.

The reaction chamber may additionally comprise susceptive functional parts, such as graphite substrate holders, rings, and upstream and downstream cover elements.

Both functional and structural susceptive parts may be provided with suitable coatings to protect the chamber from contamination and increase its lifetime. Typical coatings include TaC or poly-SiC coatings with a surface roughness below 6,3 µm Ra, more typically below 1 µm Ra.

The reaction chamber may additionally comprise non susceptive parts, such as smooth polycrystalline SiC elements, which may be employed in one or more structural parts, such as the lateral walls.

During an epitaxial deposition process, one or more semiconductor layers grow in a controlled fashion on a rotating substrate.

However, during the epitaxial deposition on a substrate of monocrystalline silicon carbide, typically 3C, 4H or 6H silicon carbide polytypes, users have observed parasitic silicon carbide growth on certain structural and functional parts of the reaction chamber.

It is noted that this undesired silicon carbide build-up typically comprises polycrystalline and/or amorphous silicon carbide and is difficult to remove because of the hardness of the material.

The above parasitic phenomenon is particularly relevant in hot-wall reactors, where it is prevalently impacting the upstream end of the chamber (i.e., where the precursor gases enter the reaction chamber), as well as the elements surrounding the substrate or in contact with the same.

It is noted that undesired SiC buildup occurs both on bare and coated surfaces of the reaction chamber.

It has been observed that the parasitic deposition of SiC films on reaction chamber parts often results in the rapid growth of cauliflower-like, porous, dendritic-like structures, which eventually affect the quality of the deposited layers on the semiconductor substrates. These parasitic films have an uneven appearance, with macroscopic rugosity.

In order to prevent the negative effects of parasitic films on the deposition process, the reaction chamber is subject to frequent Preventive Maintenance (PM) operations.

PM operations negatively impact the productivity of the reactor, thereby heavily affecting the economics of the epitaxial deposition process.

During PM, the machine is cooled and purged, and some or all affected parts are manually removed from the chamber for mechanical cleaning, disposal, and/or substitution. These manual operations often yield to non-reproducible results.

The removal of SiC with etching methods has been explored in the art for other applications. These methods, however, typically discuss the removal of just a few top layers of orderly SiC from bulk SiC pieces, such as described in US20140030892A1 and US20060001028A1.

The chemical etching of SiC in these instances takes place in the absence of an underlying workpiece (of potentially different composition) that may be damaged in the process. These processes typically remove only few microns of SiC.

It is noted that SiC is characterized by a 9-10 Mohs hardness and it is difficult to attack via chemical means without eventually damaging the concerned reactor workpieces. Additionally, the silicon and carbon components of SiC behave differently when exposed to chemical attack.

The methods disclosed in US20140030892A1 and US20060001028A1 address specific surface defects of the SiC piece concerned, respectively: warpage of monocrystalline SiC substrates and surface cracks of SiC substrate holders. These methods do not address the removal of disorderly parasitic SiC deposits without detriment to the affected reaction chamber parts.

It is therefore desirable to provide a method for the removal of polycrystalline-amorphous SiC parasitic build-up from concerned parts of a reaction chamber without damaging said parts.

It is also desirable to provide a method for removing polycrystalline/amorphous SiC parasitic build-up that is effective, reproducible, and reliable.

Additionally, it is desirable to provide an assembly configured to execute the above-mentioned method.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art. In particular, it is an object of the present invention to provide a method for the removal of SiC parasitic build-up from concerned parts of a reaction chamber.

It is another object of the invention to provide a method for removing polycrystalline/amorphous SiC parasitic build-up that is effective, reproducible, and reliable and preserves the reactor parts concerned.

Additionally, it is an object of the invention to provide an assembly configured to execute the above-mentioned method.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

### BRIEF DESCRIPTION OF THE FIGURES

The illustrations presented herein are not meant to be actual views of any particular material, structure, or device, but are merely idealized representations that are used to describe embodiments of the disclosure.
FIG. 1 is a picture of a reaction chamber workpiece exhibiting an accretion.
FIG. 2 illustrates an embodiment of the method according to the invention.
FIG. 3 illustrates an embodiment of the method according to the invention.
FIG. 4 illustrates an assembly in accordance with one embodiment of the invention.
FIG. 5 illustrates an assembly in accordance with one embodiment of the invention.
FIG. 6 illustrates an assembly in accordance with one embodiment of the invention.
FIG. 7 illustrates an assembly in accordance with one embodiment of the invention.
FIG. 8 illustrates an assembly in accordance with one embodiment of the invention.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure.

It will be appreciated that elements in the figures are illustrated for simplicity and clarity. In particular some elements may have been omitted or may have not necessarily been drawn to scale. For example, the dimensions of some of the elements in the figures may be exaggerated relative to other elements to help improve understanding of illustrated embodiments of the present disclosure.

Under a first aspect, the present invention relates to a method for removing an accretion 102 from one or more workpieces 104 of a reaction chamber, where the accretion comprises or consists of silicon carbide in polycrystalline and/or amorphous form.

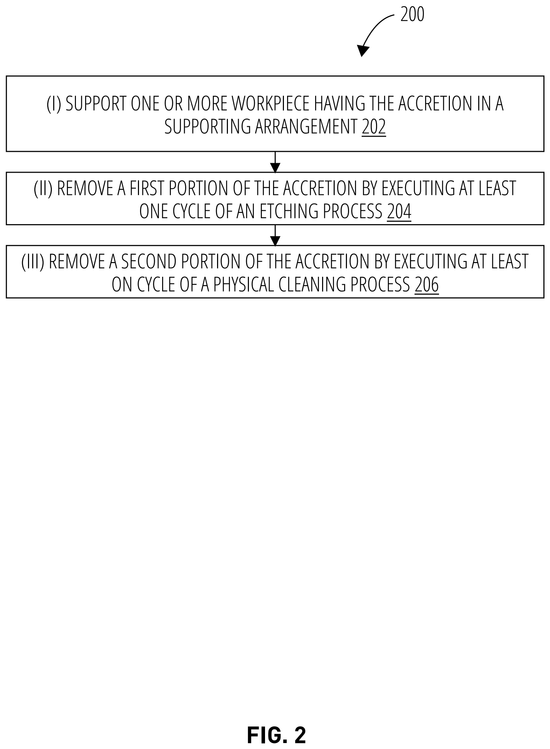

The method includes the steps of:
(i) supporting one or more workpieces having the accretion in a supporting arrangement (FIG. 2, block 202);
(ii) removing a first portion of the accretion by executing at least one cycle of an etching process (FIG. 2, block 204);
(iii) removing a second portion of the accretion, as may be resulting from the etching process, by executing at least one cycle of a physical cleaning process (FIG. 2, block 206).

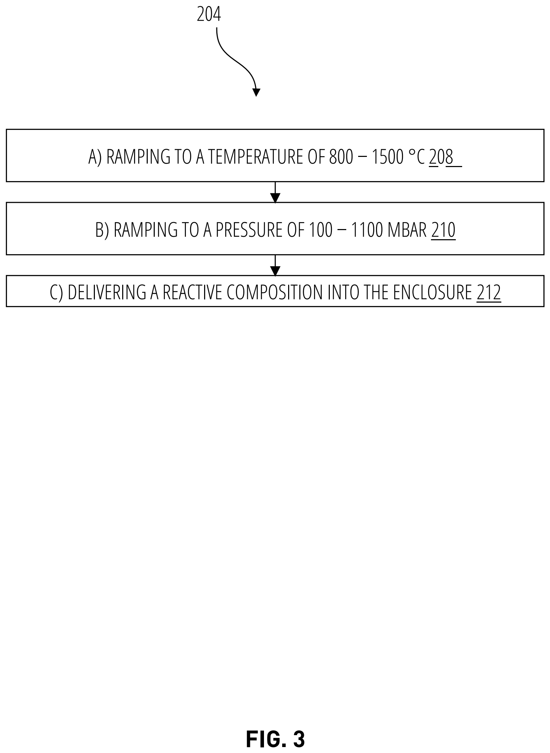

The etching process is executed in a first enclosure 404 and includes the steps of:
a) ramping the temperature inside the first enclosure to 800-1000 °C or to 1000-1500 °C (FIG. 3, block 208);
b) adjusting the pressure inside the first enclosure to 100-1100 mbar (FIG. 3, block 210);
c) delivering a reactive composition into the first enclosure (FIG. 3, block 212).

Steps a) and b) are performed by gradually adjusting pressure and temperature conditions from a starting value to the desired process value, thereby protecting the first enclosure and the workpiece from the undesired effects of abrupt changes, which may cause stress and damage to mechanical parts, and/or cause lack of uniformity of process conditions.

Once the reaction chamber has reached the desired temperature and pressure settings, the actual etching of the SiC parasitic film can take place according to step c).

The physical cleaning process is afterwards executed with a mechanical device 702 and/or a pneumatic device.

The reactive composition comprises one or more reactive gases, i.e., gases suitable to react with Si and/or C for etching purposes.

In particular the reactive composition comprises at least a first reactive gas. The first reactive gas may be an inorganic chlorinated species, such as HCl, Cl₂, ClF₃, or CCl₄.

The reactive composition also comprises a carrier gas; which is preferably an inert gas. For example, the inert gas may be nitrogen, or, preferably, helium or argon to avoid contamination of the workpiece.

The molar concentration of the first reactive gas into the carrier gas is 15-40%.

Advantageously, the carrier gas may be used to tailor and control the concentration and distribution of the reactive gas in the first enclosure.

The workpiece is typically a part of the reaction chamber of a reactor for the deposition of one or more silicon carbide layers on a substrate. For example, a crossflow, horizontal reactor.

A workpiece may indicate a removable or fixed part of the reaction chamber, such as covers, rings, or walls, whether stationary or rotating.

The workpiece may specifically be a graphite part, optionally coated with TaC, pyrolytic graphite, or poly-SiC.

"Supporting arrangement" refers to a system comprising at least one first workpiece holder, optionally provided with a workpiece seat adapted to securely lodge and position the workpiece during the execution of the etching process, and, optionally, the physical cleaning process.

This first workpiece holder may be adapted to withstand the temperature and pressure conditions of the etching process. It may be located within the first enclosure during the execution of one or more cycles of the etching process.

The supporting arrangement may further comprise a second workpiece holder, which may be optionally equipped with a workpiece seat and be used to support and position the workpiece during the physical cleaning process.

Both the first and second workpiece holder, if present, may be fixed elements within the same or different enclosure, or alternatively rotatable, and/or removable, and/or used to transport the workpiece.

The first enclosure where the etching process takes place may not be the only enclosure used in the execution of the method according to the invention. For example, the physical cleaning process may be carried out in the same or in a different enclosure. For the avoidance of doubt, the enclosure used in the execution of the etching process will be also referred to as "first enclosure," to distinguish it from any other enclosures used, if needed, and if any.

The first portion 410 of the accretion is the outermost portion, with at least one surface fully exposed to the environment.

The second portion 412 of the accretion, which is removed and/or removable with the physical cleaning process, is obtained and/or revealed by the etching process, after the chemical etching of the first portion.

In particular, the second portion may comprise newly exposed parts of the original accretion after etching.

In any case, the second portion may comprise or consist of a pulverulent structure, such as a powder, obtained as consequence of etching the first portion of the accretion with the reactive composition.

Indeed, the etching process is conducted using chemicals that react with the parasitic deposition, leading to gas phase byproducts. Because of the disorderly nature and the peculiar morphology of the accretions, which is rough (such as above 6,3 µm Ra) and prone to the formation of voids, the etching process may also lead to powder byproducts.

The above-mentioned powder may be carbon rich, as the result of a higher Si selectivity of the etching process, in case the only reactive gas in the reactive composition is Cl₂.

Advantageously, this pulverulent byproduct of the etching process can be easily removed with physical cleaning processes having no or negligible invasiveness, i.e., without damaging the workpiece, and preserving any optional protective coating applied thereon.

The method according to the invention may advantageously provide an effective and reproducible process for cleaning reaction chamber parts subject to parasitic build-up and increase their lifetime.

In particular, the combination of a chemical and physical cleaning steps (respectively the claimed etching process and physical cleaning process) proves instrumental in solving the long felt need in the silicon carbide epitaxial industry of reducing the impact of preventive maintenance operation on reaction chamber parts (workpieces). While the removal of SiC accretions from workpieces is necessary to ensure satisfactory deposition quality, the rapid deterioration of these parts heavily drives the cost of ownership of SiC epitaxial reactors.

The sequential combination of chemical and physical cleaning steps allows to reduce the aggressiveness of each step, in terms of process conditions and, to an extent, the chemicals used, compared to a situation where they would be carried out individually. This may better preserve the integrity of the workpiece while obtaining improved cleaning results, by taking advantage of the specific strengths of each method.

For example, Cl₂, which is less aggressive than other chlorinated species, may be advantageously used as first reactive gas, and step a) may be conducted ramping the temperature inside the first enclosure to 800-1200°C.

In this case, chlorine may be selected with a purity equal to or greater than 99.990%, even more preferably with a purity equal to or greater than 99.998%.

In general, the person with average skill will adjust the duration and process conditions of the etching process hereinbefore described based on the extension and thickness of the first portion of the accretion to be removed, and in consideration of the workpiece (dimensions and composition) to be preserved.

The thickness and irregularity of the first portion of the accretion is usually dependent on the thickness of the silicon carbide layer deposited on a substrate in the reactor.

Since it is generally challenging to define the thickness of the irregular accretion, the equivalent thickness of the silicon carbide layer may be used as reference, since it is a set parameter of the deposition process in a reactor.

The etching process may be advantageously executed for 0,12-0.3 minutes per µm of equivalent thickness T.

It is noted that the accretion may comprise polycrystalline and/or amorphous silicon carbide. Typically, it is a mixture of both polycrystalline and amorphous silicon carbide. For example, XRD measurements often show a mixture of 20-60% of amorphous SiC and 40-80% of polycrystalline SiC, though their relative ratio may vary and may be subject to significant local and absolute variations.

For the avoidance of doubt, here and in the following, the accretion may be directly obtained or obtainable as parasitic deposition of SiC on a workpiece of a reaction chamber during the epitaxial deposition process of SiC layers on a rotating substrate inside the reaction chamber.

The expression "accretion" shall be deemed equivalent to "SiC film," "parasitic SiC film" or "parasitic SiC deposits," unless otherwise specified, and will refer to SiC in polycrystalline and/or amorphous form, and typically to a mixture of both.

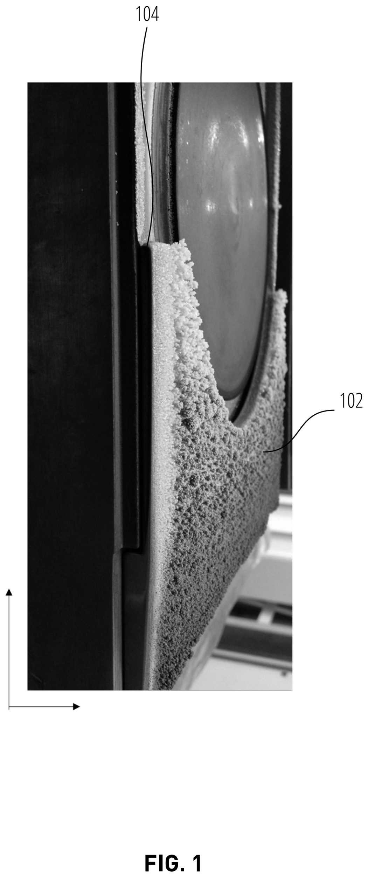

Furthermore, the accretions may not exhibit a bidimensional regular and/or orderly geometry. On the contrary, it refers to an uneven SiC coat formed on one or more surfaces of impacted parts of a reaction chamber. It typically exhibits a three-dimensional structure, or a rough gritty surface, as in the picture provided in FIG. 1,

The parasitic accretion is the result of uncontrolled growth on reaction chamber parts during the epitaxial SiC layer deposition on a rotating substrate.

The term "accretion" and "layer" are used here and in the following to respectively distinguish the undesired parasitic SiC deposits (accretions) from the desired, controlled and typically monocrystalline SiC layers deposited on a substrate.

In general, the parasitic accretions exhibit an uneven surface, with apparent rugosity and variable thickness. The unevenness of the surface, often clearly visible to the naked eye, is usually, but not necessarily accompanied by a cauliflower- or fractal-like structure, with visible macroscopic dips and protrusions, possibly due to a dendritic-like growth process.

Under an embodiment, the etching process further includes a cooling step:
d) adjusting the temperature of the first enclosure to a value below 1000 °C and flowing a cooling gas at a pressure of 100-1000 mbar inside the first enclosure.

Step d) is executed after step c).

Non-limiting examples of cooling gases include helium, nitrogen, hydrogen, and combinations thereof.

Under one embodiment, the method may also include a step e) of executing a purging process.

Under some embodiments, the purging process includes the sub-steps of: adjusting the pressure of the first enclosure to ≤ 1 mbar and flowing an inert gas to reach a pressure of 100-1000 mbar inside the first enclosure.

The purging process is executed 1-20 times after step c) or d).

It is noted that the cooling step d) may be advantageously used to set up favorable conditions to execute the purging process e). Conversely, the latter may help achieve the effects of the cooling step more efficiently, depending on the order in which they are executed.

It may be beneficial to optionally execute 1-20 cycles of the purging process, thus removing all traces of the reactive gases used, as well as any by-products of the etching process that may be still present in the first enclosure before accessing the workpiece.

Under one embodiment, during step b), the pressure inside the first enclosure is ramped to 100-500 mbar.

Under one embodiment, the first reactive gas is delivered at a flow rate of 5-15 slm (standard liters per minute).

Under one embodiment, the reactive composition further includes a second reactive gas and said second reactive gas is H₂ or O₂.

Under one embodiment, the mechanical device is a brush, sponge, or a grinding device, such as a handheld mill.

It is generally preferable to select a non-invasive mechanical device, such as brush, thus taking full advantage of the pulverulent nature of the second portion of the accretion to be removed and prolong the lifetime of the workpiece.

Analogously, a pneumatic device is also a particularly advantageous embodiment.

Under one embodiment, the pneumatic device is a compressed air device, or a device adapted to deliver a compressed inert gas, such as N₂ or Ar.

The air or inert gas may be advantageously delivered at a pressure of 15-35 bar.

The pneumatic device mentioned above may beneficially preserve the workpiece to be cleaned, while effectively and reproducibly removing the second portion of the accretion. This step can also be easily and advantageously automated.

The method hereinbefore described may be carried out in an assembly 400 expressly designed to this effect.

"Assembly" refers to an apparatus comprising one or more components. In case of a plurality of components, they may be optionally configured to communicate with each other and allow manual or automated movement of one or more workpieces between the components, for instance through resealable passage ports, doors, or openings, via an operator, a robotic device, or a conveyor belt.

In a second aspect, the invention relates to an assembly 400 adapted to carry out the method described above.

The assembly includes at least a first enclosure 604. The enclosure is preferably sealed or sealable, and/or pressure and/or vacuum resistant. For example, the enclosure may be a quartz tube.

The assembly further includes a heating system adapted to ramp the temperature inside the chamber up to 800-1000 °C or to 1000-1500 °C, which is to say 800-1500 °C.

Under some embodiments, preferably the temperature is 1200-1500 °C for a faster etching process on thick accretions.

Under some embodiments, preferably the temperature is 800-1200 °C to better preserve the workpiece during the etching process and to take full advantage of the subsequent integrated physical cleaning process for achieving complete cleaning and refurbishing of the workpiece.

The heating system may include one or more heating lamps 414, and/or one or more electrical resistances, and/or one or more inductions systems, such as induction coils 500.

The assembly includes at least one inlet 416 connected or contactable to an injection system configured to deliver a reactive composition into the first enclosure

The assembly further includes at least one outlet 418 connected or connectable to an exhaust line and adapted to discharge exhaust gases out of the first enclosure.

The supporting arrangement includes at least a first workpiece holder situated inside the first enclosure. The first workpiece holder includes a workpiece seat configured to support a workpiece during the removal of a first portion of an accretion, during one or more cycles of the etching process.

Under one embodiment, the assembly may also include a chamber 406, 502, situated inside the first enclosure. The first workpiece holder is situated inside the chamber, and at least one inlet and said at least one outlet are located on the chamber.

The chamber may be removable or fixed with the assembly.

The assembly may optionally be characterized in that the first enclosure is a quartz tube. The assembly may comprise an induction coil wrapped around the quartz tube.

The assembly may comprise a chamber situated inside the first enclosure.

The assembly may comprise a thermal insulation system made of porous carbonaceous materials, for instance carbon composites made from short cut carbon fibers, optionally interconnected in a matrix, or pressed together, composed of one or more thermally insulating shells.

The chamber may be enclosed within the thermal insulation system.

Under one embodiment, the assembly may also include an outer case 402. The outer case may be made of stainless steel. It may also be advantageously chosen as pressure and vacuum resistant.

Under one embodiment, the assembly may also include a vacuum system adapted to adjust the pressure inside the chamber to 100-500 mbar.

Under one embodiment, the supporting arrangement may also include at least a second workpiece holder 600, which may be optionally situated inside the above first enclosure or in a second enclosure 606. The second workpiece holder may include a workpiece seat configured to support the workpiece 104 during the removal of a second portion of an accretion.

Advantageously the assembly is configured to provide one sole platform for the execution of all steps of the method herein disclosed.

Under one embodiment, the assembly may also include a second enclosure; with the first enclosure being adapted to carry out at least one cycle of the etching process, and the second enclosure being adapted to carry out at least one cycle of the physical cleaning process.

Under some embodiments, the first enclosure and the second enclosure may be mutually connected to each other so that the assembly can be in two different settings, i.e., working configurations.

In a first configuration, the two enclosures are sealed with respect to each other, for example during the execution of the etching step.

In a second configuration, the two enclosures are set in fluidic communication with each other to allow the transfer of the workpiece from the first enclosure to the second enclosure.

In some embodiments the assembly includes automated means, which may be used to transfer the workpiece from the first enclosure to the second enclosure in an automated fashion.

Advantageously this embodiment allows to sequentially execute the etching process and the physical cleaning process without manual intervention between steps ii) and iii), thus providing and improved assembly in terms of safety and processing times.

Under one embodiment, the assembly may also include a thermal insulation system. The thermal insulation system may be made of porous carbonaceous materials, for instance carbon composites made from short cut carbon fibers, optionally interconnected in a matrix, or pressed together. The thermal insulation system may be composed of one or more thermally insulating shells.

The assembly may also include mass flow controllers (MFC 808), valves, isolation valves 806, throttle valves 804, vacuum pumps 802, scrubbers 800.

The first enclosure 604 and the second enclosure 606 may include port holes, doors, or other access points, so that, optionally, they may be mutually connected to each other via a sealable aperture.

Advantageously, in this case the workpiece may be transferred from the first enclosure to the second enclosure in an automated fashion.

The second enclosure 606 may be a globe glove box 700.

Under some embodiments, the assembly according to the invention additionally comprises at least one processor, at least one memory unit, at least one temperature control device, and at least one pressure control device.

The processor may be configured to execute instructions stored in the memory unit to control the execution of one or more steps of the method in accordance with a predefined recipe. The predefined recipe may include steps a), b), c), and optionally steps d) and e)] of the method according to the invention. The processor may be adapted to receive a temperature input from a user and to cause the temperature control device to ramp the temperature inside the first enclosure to a value equal to the temperature input, where the temperature input is between 800 and 1500 °C;

The processor may also be adapted to receive a pressure input from a user and to cause the at least one pressure control device to ramp the pressure inside the first enclosure to a value equal to the pressure input, where the pressure input is between 100 and 1100 mbar.

The processor may also be configured to control gas delivery components, including mass flow controllers and valves, to deliver the reactive composition through the injection system according to the predefined recipe.

Under some embodiments, at least one processor of the assembly is configured to implement a temperature and pressure ramp profile stored in the memory unit to gradually adjust from a starting value to a process value for steps a) and b), thereby protecting the first enclosure and the workpiece from abrupt temperature and pressure changes.

The subject matter of the present disclosure includes all novel and nonobvious combinations and subcombinations of the various processes, systems, and configurations, and other features, functions, acts, and/or properties disclosed herein, as well as any and all equivalents thereof.

FIG. 1 is a picture of an accretion 102 deposited on a graphite workpiece 104 of a hot wall reaction chamber of an epitaxial SiC reactor as the result of a parasitic deposition process.

FIG. 2 illustrates an example routine 200 for the method according to the invention. Although the example routine 200 depicts a particular sequence of operations, the sequence may be altered without departing from the scope of the present disclosure. For example, some of the operations depicted may be performed in parallel or in a different sequence that does not materially affect the function of the routine 200. In other examples, different components of an example device or system that implements the routine 200 may perform functions at substantially the same time or in a specific sequence.

According to some examples, the method includes: (i) supporting one or more workpiece having the accretion in a supporting arrangement at block 202.

According to some examples, the method includes: (ii) removing a first portion of the accretion by executing at least one cycle of an etching process at block 204.

According to some examples, the method includes: (iii) removing a second portion of the accretion by executing at least on cycle of a physical cleaning process at block 206.

FIG. 3 illustrates an example routine for the etching process.

According to some examples, the etching process includes: a) ramping to a temperature of 800-1500°C at block 208 (but preferably 800-1200°C or 1200-1500 °C), b) ramping to a pressure of 100-1100 mbar at block 210; c) delivering a reactive composition into the first enclosure at block 212. The system comprises a block 204.

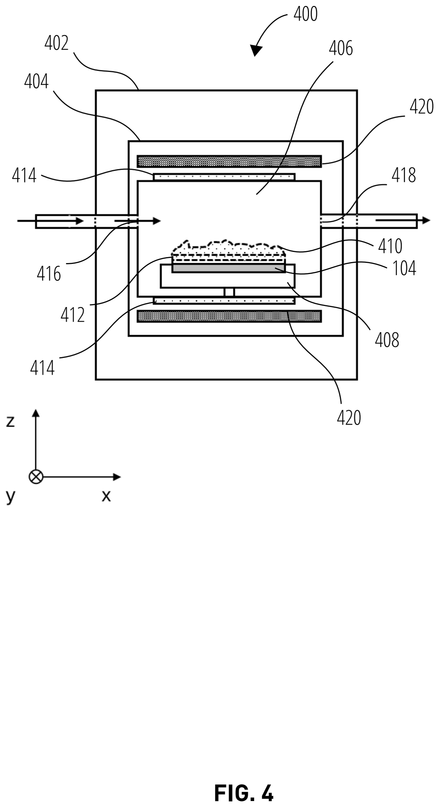

FIG. 4 provides a schematic illustration of the assembly 400 for removing a first portion 410 and a second portion 412 of an accretion covering a workpiece 104. The figure is a cross section of the assembly 400 in the (xz) plane. The accretion is the result of a parasitic buildup during an epitaxial deposition process. The assembly comprises a stainless-steel outer case 402, a sealable first enclosure 404, and a chamber 406.

In this embodiment, the workpiece 104 is placed on a first workpiece holder 408 inside the chamber. The chamber is heated with lamps 414 and is thermally insulated with the thermal insulation system 420.

To execute the etching process, the reactive composition is delivered in the chamber along the (x) direction through the inlet 416, which is positioned on a first chamber wall parallel to the (yz) plane. The reactive gas interacts with the first portion 410 of the accretion, leaving the second portion 412 exposed and leaving the chamber through the outlet 418, positioned on a second wall parallel to the (yz) plane. The second portion may include or consist of dust and particles resulting from the etching process.

The chamber may be cooled by executing a cooling step and/or purged by executing one or more purging processes. This step may be used to reach any temperature between room temperature and 900 ° C, depending on the stage at which it is executed.

The second portion may then be removed by carrying out the physical cleaning process on the workpiece. To this effect, the latter may be left inside the chamber and accessed through suitable resealable apertures (not shown), or removed treated elsewhere, such as in a different partition of the same first enclosure 404, in a separate second enclosure (inside or outside the same outer case 402, or in an open environment.

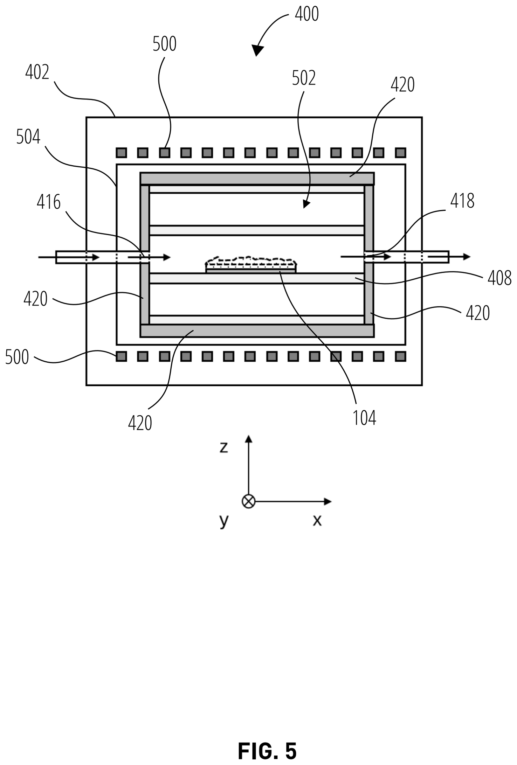

FIG. 5 provides a simplified sketch of the assembly 400 according to an embodiment of the invention. The sketch represents a cross section of the assembly 400 in the (xz) plane. The assembly comprises a first workpiece holder 408 supporting a workpiece 104 inside the reaction chamber 502. The reaction chamber is provided with an inlet 416 and an outlet 418. The reaction chamber is mostly covered by a thermal insulation system 420 consisting of multiple insulation shells. This arrangement is contained inside an enclosure, in this case the quartz tube 504. An induction coil 500, which is an element of an induction heating system is wrapped around the quartz tube 504. an outer case 402.

In this embodiment, a removable reaction chamber of a reactor for the epitaxial deposition of silicon carbide is used as "chamber" for the assembly. The reaction chamber is therefore moved between the reactor and the assembly, without the need to swap from the reaction chamber the workpieces to be treated.

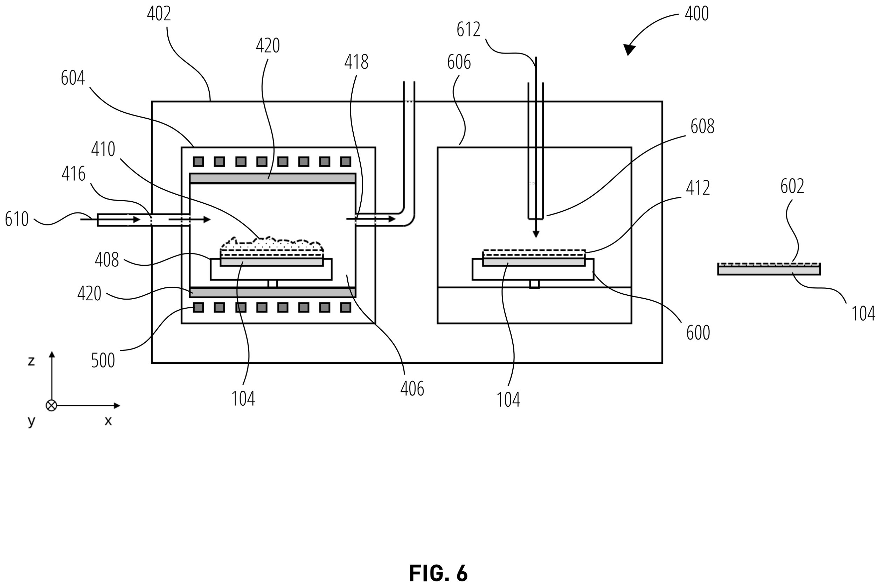

FIG. 6 illustrates a cross section of an embodiment of the assembly 400 in the (xz) plane. The assembly comprises a first enclosure 604 and a second enclosure 606, which define separate enclosed spaces respectively dedicated to the etching process and the physical cleaning process and both positioned within one outer case 402.

The first enclosure 604 is equipped with a first workpiece holder 408 to support a workpiece 104 inside a chamber 406. The workpiece features an accretion having a first portion 410 to be etched with a reactive composition. The reactive composition flow 610 enters into the chamber 406 through an inlet 416 and is discharged through an outlet 418 after reacting with the accretion.

The chamber 406 is enclosed win a thermal insulation system 420 and is inductively heated with an induction coil 500.

The second enclosure 606 is equipped with a second workpiece holder 600, to support the workpiece 104 having a second portion 412 of the accretion to be cleaned.

The physical cleaning process is performed with a pneumatic device injecting a compressed air flow 612 through the inlet 608.

The clean workpiece 104, featuring a coating 602, preserved after the execution of the method according to the invention, may then be retrieved from the assembly. It is noted that the etching process and the physical cleaning process may be performed on different workpieces at the same time.

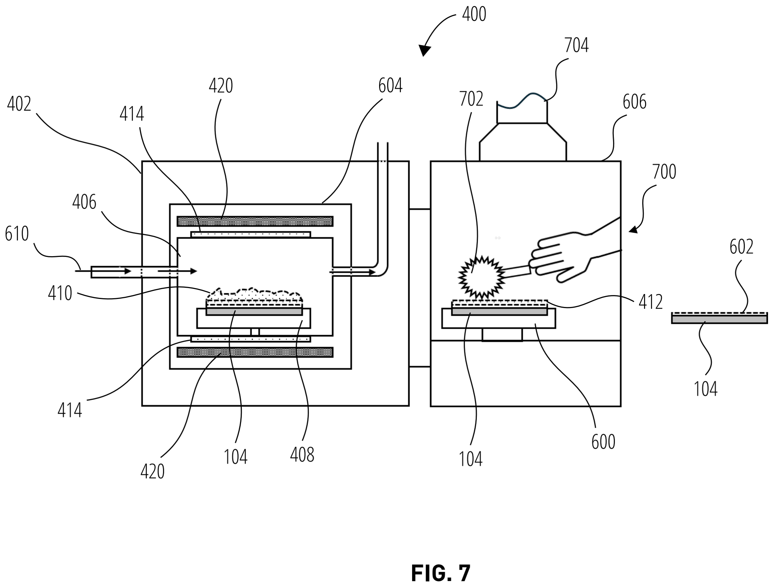

FIG. 7 illustrates a simplified cross section of the assembly 400 in the (xz) plane.

The assembly comprises an outer case 402, enclosing a first enclosure 604 and a second enclosure 606, respectively dedicated to the execution of the etching process and the physical cleaning process.

The first enclosure contains a chamber 406, hosting a first workpiece holder 408 for a workpiece 104 having a first portion 410 of an accretion to be removed under a reactive composition flow 610.

The chamber 406 is heated with a lamp 414 and is thermally insulated with the thermal insulation system 420.

The second enclosure 606 is a glove box 700, equipped with a hood 704 and provided with the mechanical device 702 to remove a second portion 412 of an accretion on a workpiece placed in a second workpiece holder 600.

The clean workpiece 104, featuring a coating 602, preserved after the execution of the method according to the invention, may then be retrieved from the assembly. It is noted that the etching process and the physical cleaning process may be performed on different workpieces at the same time.

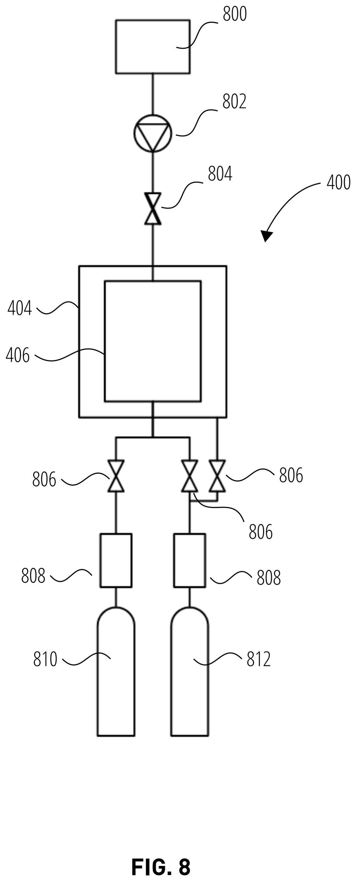

Fig.8 provides a schematic layout of an assembly 400 according to the invention. The assembly comprises at least two vessels containing a first reactive gas 810, and an inert gas 812. These gases are delivered through an MFC 808 and isolation valves 806 into the chamber 406. The chamber is located in an first enclosure 404. After use, the reactive composition is discharged to a scrubber 800, after the pump 802 and the throttle valve 804.

## Claims

1. A method for removing an accretion from one or more workpieces, comprising the steps of:
(i) supporting one or more workpieces having the accretion in a supporting arrangement, said accretion comprising silicon carbide in polycrystalline and/or amorphous form;
(ii) removing a first portion of the accretion by executing at least one cycle of an etching process;
(iii) removing a second portion of the accretion by executing at least one cycle of a physical cleaning process;
wherein the etching process is executed in an first enclosure and comprises the steps of:
a) ramping the temperature inside the first enclosure to 800-1500°C;
b) ramping the pressure inside the first enclosure to 100-1100 mbar;
c) delivering a reactive composition into the first enclosure;
wherein said physical cleaning process is executed with a mechanical device and/or a pneumatic device; and
wherein said reactive composition comprises at least a first reactive gas and a carrier gas; wherein the carrier gas is an inert gas; and wherein the first reactive gas is an inorganic chlorinated species, and the molar concentration of the first reactive gas into the carrier gas is 15-40%.

2. The method of claim 1, wherein step b) is executed by ramping the pressure inside the first enclosure to 100-500 mbar.

3. The method of claim 1 or 2, wherein the etching process further comprises a cooling step d) to be executed after step c) and comprising:
d) adjusting the temperature of the first enclosure to a value below 1000 °C and flowing a cooling gas at a pressure of 100-1000 mbar inside the first enclosure.

4. The method of any one of claims 1 to 3, further comprising the step e) of executing a purging process, wherein said purging process comprises the sub-steps of:
- adjusting the pressure of the first enclosure to ≤ 1 mbar; and
- flowing an inert gas to reach a pressure of 100-1000 mbar inside the first enclosure;
wherein said purging process is executed 1-20 times after step c) or d).

5. The method of any one of claims 1 to 4, wherein the carrier gas is nitrogen, argon, or helium.

6. The method of any one of claims 1 to 5, wherein the first reactive gas is delivered at a flow rate of 5-15 slm.

7. The method of any one of claims 1 to 6, wherein the accretion is obtained on one or more workpieces of a reaction chamber as by-product of one or more epitaxial deposition processes of monocrystalline silicon carbide layers on a rotating substrate executed in the reaction chamber of a reactor.

8. The method of any one of claims 1 to 7, wherein the inorganic chlorinated species comprises HCl, Cl₂, ClF₃, or CCl₄.

9. The method of any one of claims 1 to 8, wherein the reactive composition further comprises a second reactive gas and said second reactive gas is H₂ or O₂.

10. The method of any one of claims 1 to 9, wherein the mechanical device is a brush, sponge, or a grinding device.

11. The method of any one of claims 1 to 9, wherein the pneumatic device is a compressed air device, or a device adapted to deliver a compressed inert gas.

12. The method of any one of claims 1 to 11, wherein the workpiece is a graphite part.

13. An assembly adapted to carry out the method according to any one of claims 1 to 12, said assembly comprising:
- at least a first enclosure;
- a heating system adapted to ramp the temperature inside the first enclosure to 800-1500 °C;
- at least one inlet connected or contactable to an injection system adapted to deliver a reactive composition into the first enclosure;
- at least one outlet connected or connectable to an exhaust line and adapted to discharge exhaust gases out of the first enclosure;
- a supporting arrangement comprising at least a first workpiece holder situated inside the first enclosure;
wherein said first workpiece holder comprises a workpiece seat configured to support a workpiece during the removal of a first portion of the accretion comprising silicon carbide in polycrystalline and/or amorphous form.

14. The assembly of claim 13, further comprising a chamber, wherein said chamber is situated inside the first enclosure; and wherein said first workpiece holder is situated inside the chamber; and wherein said at least one inlet and said at least one outlet are located on said chamber.

15. The assembly of claim 13 or 14, further comprising an outer case encasing the first enclosure.

16. The assembly of any one of claims 13 to 15, further comprising a vacuum system adapted to adjust the pressure inside the chamber to 100-500 mbar.

17. The assembly of any one of claims 13 to 16, wherein the supporting arrangement comprises at least a second workpiece holder, wherein said second workpiece holder comprises a workpiece seat configured to support a workpiece during the physical cleaning process.

18. The assembly of any one of claims 13 to 17, further comprising a second enclosure; wherein the first enclosure is adapted to carry out at least one cycle of the etching process, and said second enclosure is adapted to carry out at least one cycle of the physical cleaning process.

19. The assembly of any one of claims 13 to 18, further comprising at least one processor, at least one memory unit, at least one temperature control device, and at least one pressure control device, wherein:
- the at least one processor is configured to execute instructions stored in the memory unit to control the execution of one or more steps of the method in accordance with a predefined recipe and is adapted to receive a temperature input from a user and to cause the temperature control device to ramp the temperature inside the first enclosure to a value equal to the temperature input; the temperature input being between 800°C and 1500°C;
- the at least one processor is adapted to receive a pressure input from a user and to cause the at least one pressure control device to ramp the pressure inside the first enclosure to a value equal to the pressure input; the pressure input being between 100 and 1100 mbar; and
- the at least one processor is further configured to control gas delivery components to deliver the reactive composition through the injection system according to the predefined recipe.

20. The assembly of claim 19, wherein the at least one processor is configured to implement a temperature and pressure ramp profile stored in the memory unit to gradually adjust from a starting value to a process value for steps a) and b), thereby protecting the first enclosure and the workpiece from abrupt temperature and pressure changes.
